# EUROPEAN PATENT APPLICATION

(11) **EP 0 990 919 A2**
(43) Date of publication of application: **05.04.2000**
(21) Application number: 99307595.1
(22) Date of filing: 27.09.1999
(51) Int. Cl.: G01R 33/09

(54) **Magneto-Impedance effect element driving circuit**

(30) Priority: 01.10.1998 JP 28007498
(71) Applicant: ALPS ELECTRIC CO., LTD., Ota-ku Tokyo 145 (JP)
(72) Inventor: Sasagawa, Shinichi, Furukawa-shi, Miyagi-ken (JP); Sudo, Yoshihiro, Monou-gun, Miyagi-ken (JP); Ouchi, Junichi, Toda-gun, Miyagi-ken (JP)
(74) Representative: Kensett, John Hinton

(57) **Abstract**

Disclosed is a magneto-impedance effect element driving circuit comprising: a plurality of magneto-impedance effect elements; an exciting coil for applying a biased magnetic field to the plurality of magneto-impedance effect elements; a coil driving circuit for alternating the direction of a current flowing through the exciting coil; element driving circuits for driving the plurality of magneto-impedance effect elements in synchronism with the coil driving circuit; and a detecting circuit for detecting an end-to-end pulse voltage of each of the plurality of magneto-impedance effect elements.

## Description

The present invention relates to a driving circuit for driving magneto-impedance effect elements (called the MI elements hereunder). More particularly, the invention relates to a driving circuit for driving an asymmetrical MI element arrangement made of a first and a second MI element laid out in parallel with each other and subject to a biased magnetic field applied by an exciting coil.

What is known as the magneto-impedance effect (called the MI effect hereunder) is a phenomenon wherein a magnetic material with high permeability subject to the flow of a high-frequency current has its impedance varied under the influence of an external magnetic field through the so-called skin effect.

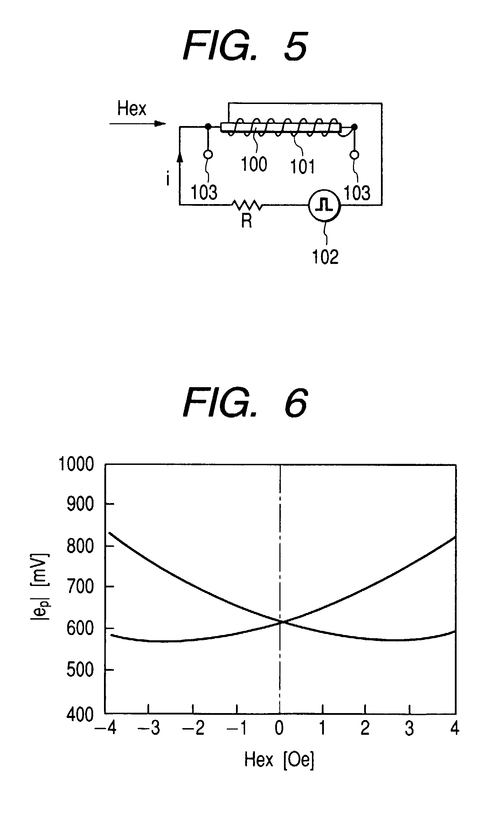

Fig. 5 is a conceptual view depicting the principle of operation of an MI element working on the basis of the MI effect. Illustratively, an exciting coil 101 is wound around a wire magnetic material 100 such as an amorphous wire with high permeability and is connected to the latter in series. A pulse oscillator 102 generates a pulse train current that flows through the exciting coil 101. This causes a pulse voltage to develop across terminals 103 at both ends of the wire magnetic material 100, the voltage being varied by an external magnetic field Hex. Measuring the voltage permits detection of the external magnetic field Hex. The principle of operation above applies illustratively to magnetic sensors.

Where the wire magnetic material 100 is used, the characteristics of the MI effect generally appear symmetrical with respect to the external magnetic field Hex. This means that, in a magnetic sensor application for example, the magnetic material must be subject to a DC biased magnetic field through the use of the exciting coil 101. When coil currents flowing through the exciting coil 101 are arranged to be in clockwise and counterclockwise relations to a wire current flowing through the wire magnetic material 100, the resulting characteristics of the MI effect turn out to be asymmetrical (see Fig. 6). This makes it possible to apply the MI effect to magnetic sensors.

Fig. 6 is a graphic representation explaining asymmetrical MI elements in terms of characteristic relations between an external magnetic field on the one hand and a pulse voltage between wire ends on the other hand. Curves in Fig. 6 represent characteristics in effect when the coil current flowing through the exciting coil 101 is arranged to flow in clockwise and counterclockwise relations to the wire current through the wire magnetic material 100.

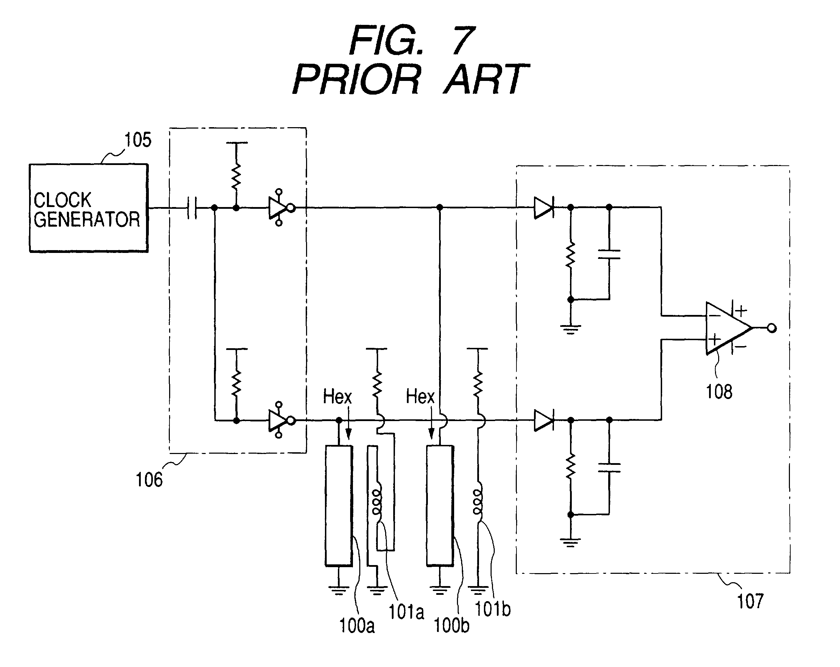

Fig. 7 is a circuit diagram of a conventional asynchronous MI element driving circuit. As shown in Fig. 7, a first wire magnetic material 100a and a second wire magnetic material 100b are positioned in parallel with each other. A first exciting coil 101a is wound around the first wire magnetic material 100a and a second exciting coil 101b around the second wire magnetic material 100b. As illustrated, the two coils are wound in the opposite directions, i.e., one clockwise and the other counterclockwise, so that a coil current through the first exciting coil 101a flows clockwise (or counterclockwise) relative to the current in the corresponding magnetic material while a coil current through the second exciting coil 101b flows counterclockwise (or clockwise) with respect to the current in the corresponding magnetic material. Using a plurality of wire magnetic materials 100 (2 wires in this example) improves the sensitivity of the circuit as a sensor and enhances its temperature characteristics.

In Fig. 7, reference numeral 105 denotes a clock generator; 106 represents an element driving circuit feeding pulse currents to the first and the second wire magnetic material 100a and 100b in keeping with a clock signal from the clock generator 105; and 107 stands for a detecting circuit comprising an operation amplifier 108 providing differential amplification of terminal outputs from the first and the second wire magnetic material 100a and 100 in order to generate a linear output with respect to external magnetic fields Hex.

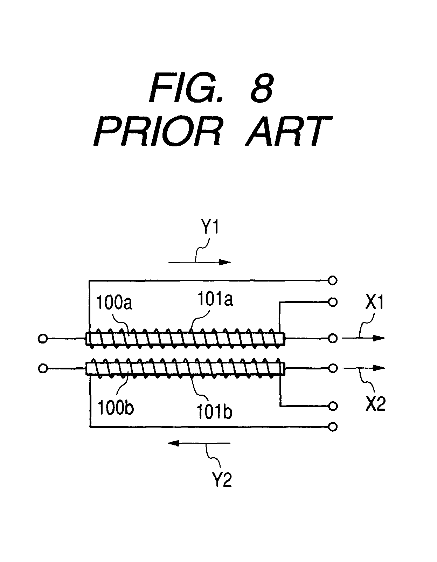

Fig. 8 is a schematic view showing how the wire magnetic materials 100a and 100b as well as the exciting coils 101a and 101b are laid out. As illustrated in Fig. 8, the first and the second wire magnetic material 100a are given dozens of turns of the first and the second exciting coil 101a respectively, the two wire magnetic materials 100a and 100b being positioned in parallel with each other. Arrows X1 and X2 indicate the direction of currents flowing through the wire magnetic materials 100a and 100b, and arrows Y1 and Y2 denote the directions of biased magnetic fields.

Techniques related to the above-described circuit arrangement are discussed illustratively in "Asymmetrical Magneto-Impedance Effect of Amorphous Wires," Journal of the Magnetics Society of Japan, Vol. 1.21, No. 4-2, 1997, as well as in Japanese Published Unexamined Patent Applications Nos. Hei 7-181239 and Hei 7-248365.

One disadvantage of the conventional driving circuit above is the difficulty of its adjustment because it uses two exciting coil 101a and 101b whose characteristics need to be matched before use. Another disadvantage of the prior art is an enlarged volume of the MI element arrangement. With the exciting coils 101a and 101b wound around the wire magnetic materials 100a and 100b that need to be laid out in parallel, the MI elements tend to be bulky. A need has been recognized for a lightweight and small-size MI element arrangement.

It is therefore an object of the present invention to overcome the above and other deficiencies of the prior art and to provide an MI element driving circuit that is small and lightweight and needs no adjustment of exciting coil characteristics.

In carrying out the invention and according to a first aspect thereof, there is provided a magneto-impedance effect element driving circuit comprising: a plurality of magneto-impedance effect elements; an exciting coil for applying a biased magnetic field to the plurality of magneto-impedance effect elements; a coil driving circuit for alternating the direction of a current flowing through the exciting coil; element driving circuits for driving the plurality of magneto-impedance effect elements in synchronism with the coil driving circuit; and a detecting circuit for detecting an end-to-end pulse voltage of each of the plurality of magneto-impedance effect elements.

According to a second aspect of the invention, there is provided a magneto-impedance effect element driving circuit comprising: a magneto-impedance effect element; an exciting coil for applying a biased magnetic field to the magneto-impedance effect element; a coil driving circuit for alternating the direction of a current flowing through the exciting coil; an element driving circuit for driving the magneto-impedance effect element in synchronism with the coil driving circuit; and a detecting circuit for detecting an end-to-end pulse voltage of the magneto-impedance effect element every time the direction of the exciting coil current is alternated.

The magneto-impedance effect element driving circuit according to the first aspect of the invention, as outlined above, needs only a single exciting coil for applying a biased magnetic field to the MI elements. Unlike the conventional setup, the inventive driving circuit has no need for adjustment of characteristics between a plurality of exciting coils. This makes it appreciably easier for the driving circuit of the invention to be assembled. Furthermore, the use of a single exciting coil is conducive to rendering the whole circuit small and lightweight.

The magneto-impedance effect element driving circuit according to the second aspect of the invention, as outlined above, needs only one MI element in addition to the single exciting coil arrangement of the first aspect. The use of a single MI element combined with the single exciting coil setup helps render the inventive circuit smaller, more lightweight and less expensive than before.

These and other objects, features and advantages of the invention will become more apparent upon a reading of the following description and appended drawings.

Embodiments of the present invention will now be described, by way of example only, with reference to the accompanying schematic drawings, in which:
Fig. 1 is a schematic view of magneto-impedance effect elements used by the invention;
Fig. 2 is a circuit diagram of a magneto-impedance effect element driving circuit practiced as a first embodiment of the invention;
Fig. 3 is a timing chart for the driving circuit in Fig. 2;
Fig. 4 is a circuit diagram of a magneto-impedance effect element driving circuit practiced as a second embodiment of the invention;
Fig. 5 is a conceptual view depicting the principle of operation of a magneto-impedance effect element;
Fig. 6 is a graphic representation explaining asymmetrical magneto-impedance effect elements in terms of characteristic relations between an external magnetic field on the one hand and a pulse voltage between wire ends on the other hand;
Fig. 7 is a circuit diagram of a conventional magneto-impedance effect element driving circuit; and
Fig. 8 is a schematic view illustrating how magneto-impedance effect elements are conventionally laid out.

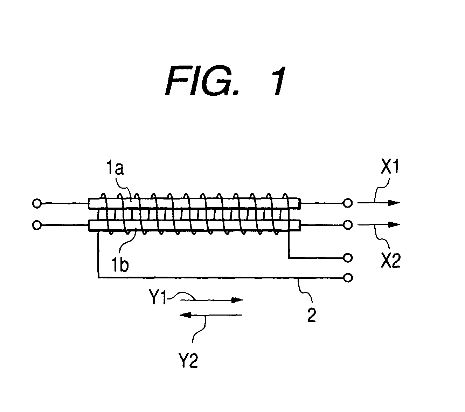

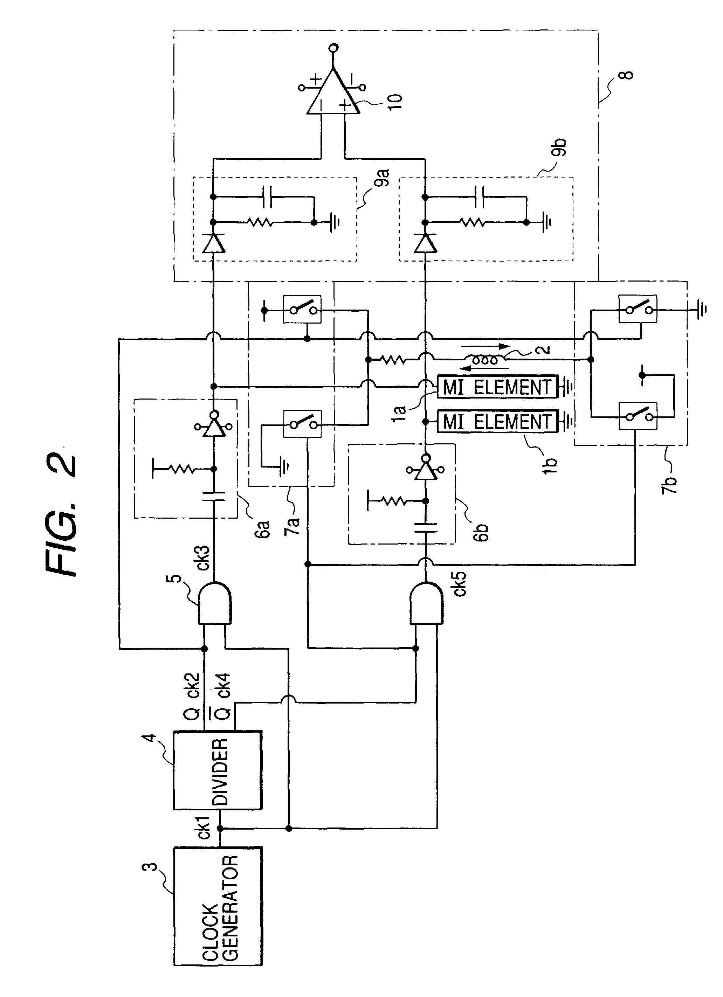

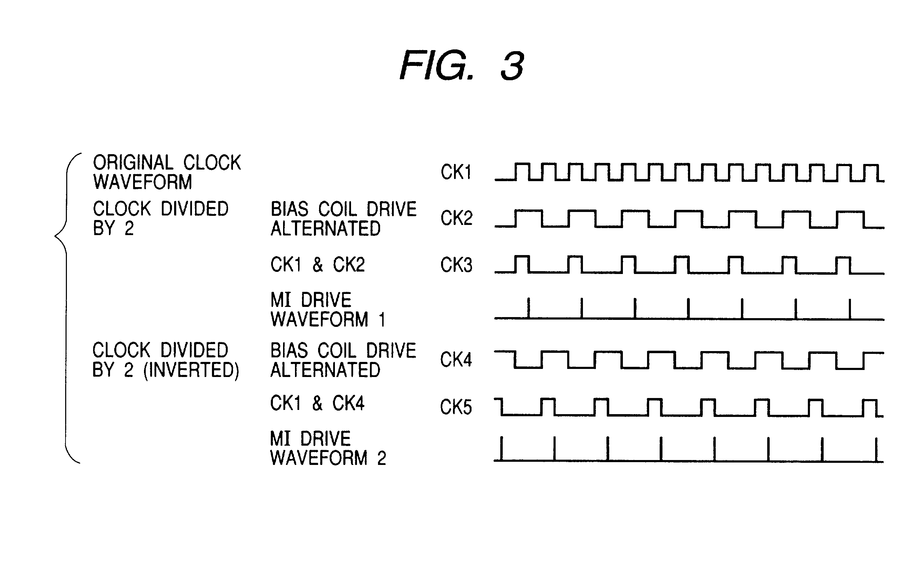

Fig. 1 is a schematic view of MI elements used by the invention, Fig. 2 is a circuit diagram of an MI element driving circuit practiced as the first embodiment of the invention, and Fig. 3 is a timing chart for the driving circuit in Fig. 2.

As shown in Fig. 1, a first wire magnetic material 1a and a second wire magnetic material 1b are laid out in parallel with each other. The wire magnetic material 1 is preferably an amorphous wire free of magnetic distortion such as an Fe-Co-Si-B alloy. The wire magnetic materials 1a and 1b are given dozens of turns of a single exciting coil that generates a DC biased magnetic field, the coil turns being made in one direction. In this arrangement, the first and the second wire magnetic material 1a and 1b are located in a core portion of the exciting coil 2.

In Fig. 2, reference numeral 3 stands for a clock generator; 4 for a divider; 5 for an AND gate; 6a for a first element driving circuit causing a pulse train current to flow through the first wire magnetic material 1a; and 6b for a second element driving circuit making a pulse train current flow through the second wire magnetic material 1b. The element driving circuits 6 are of a current output type whose current value is set for at least 10 mA. Each of the element driving circuits 6 has the gate of a digital circuit connected to a resistance R whose impedance is at least 10 times that of the corresponding wire magnetic material 1.

Reference numeral 7a and 7b denote coil driving circuits comprising switching elements for turning on and off the supply of power to the exciting coil 2. The coil driving circuits 7a and 7b periodically alternate the direction of the biased magnetic field generated by the exciting coil 2 (see arrows Y1 and Y2 in Fig. 1). Reference numeral 8 represents a detecting circuit including a first smoothing part 9a, a second smoothing part 9b, and an operation amplifier 10 providing differential amplification given output signals from the two smoothing parts 9a and 9b.

Fig. 3 is a timing chart applicable to the asynchronous MI element driving circuit in Fig. 2. As shown in Fig. 3, clock signals CK2 and CK4 are used to alternate periodically the direction of the biased magnetic field generated by the exciting coil 2. MI drive waveforms 1 and 2 are used to drive the first and the second wire magnetic material 1a and 1b in synchronism with the coil drive.

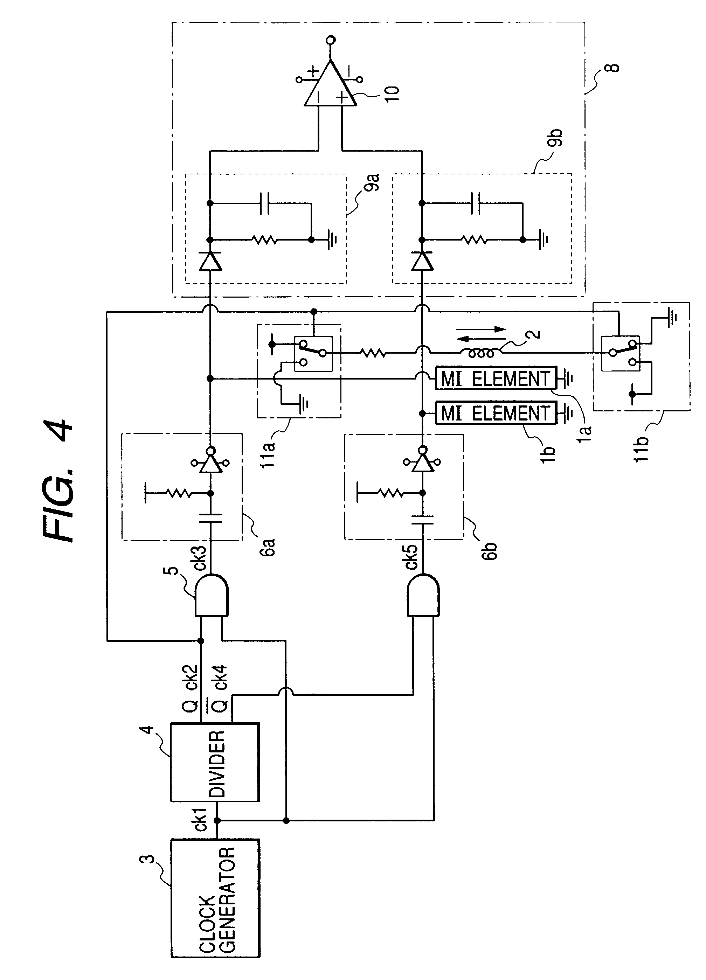

Fig. 4 is a circuit diagram of a magneto-impedance effect element driving circuit practiced as the second embodiment of the invention. What makes the second embodiment different from the driving circuit of Fig. 2 is that the circuit of Fig. 4 uses a double-pole analog switch in each of the coil driving circuits 11a and 11b. This arrangement simplifies the circuit constitution.

The first and the second wire magnetic material 1a and 1b are laid out in parallel with each other in the above embodiments. However, this is not limitative of the invention. Alternatively, the two magnetic materials may be positioned at right angles to each other. In addition, although the above embodiments were shown using two wire magnetic materials, three or more magnetic materials may be used alternatively.

The above embodiments employ a plurality of MI elements each. As a third embodiment of the invention, there may be provided a driving circuit comprising: a single MI element; a single exciting coil for applying a biased magnetic field to the MI element; a single coil driving circuit for alternating the direction of a current flowing through the exciting coil; an element driving circuit for driving the MI element in synchronism with the coil driving circuit; and a detecting circuit for detecting an end-to-end pulse voltage of the MI element every time the direction of the exciting coil current is alternated.

The MI element driving circuit may be used illustratively as a driving circuit for use in magnetic sensors and magnetic direction sensors for detecting and measuring the intensity, direction and distribution of magnetic fields.

As described, the magneto-impedance effect element driving circuit practiced in the first embodiment needs only a single exciting coil for applying a biased magnetic field to the MI elements. Unlike the conventional setup, the driving circuit has no need for adjustment of characteristics between a plurality of exciting coils. This makes it appreciably easier for the driving circuit of the invention to be assembled. Furthermore, the use of a single exciting coil is conducive to rendering the whole circuit small and lightweight.

The magneto-impedance effect element driving circuit practiced in the third embodiment needs only one MI element in addition to the single exciting coil arrangement of the first embodiment. The use of a single MI element combined with the single exciting coil setup helps render the circuit smaller, more lightweight and less expensive than before.

As many apparently different embodiments of the driving circuit may be made without departing from the spirit and scope thereof, it is to be understood that the circuit is not limited to the specific embodiments thereof except as defined in the appended claims.

## Claims

1. A magneto-impedance effect element driving circuit comprising:
a plurality of magneto-impedance effect elements;
an exciting coil for applying a biased magnetic field to said plurality of magneto-impedance effect elements;
a coil driving circuit for alternating the direction of a current flowing through said exciting coil;
element driving circuits for driving said plurality of magneto-impedance effect elements in synchronism with said coil driving circuit; and
a detecting circuit for detecting an end-to-end pulse voltage of each of said plurality of magneto-impedance effect elements.

2. A magneto-impedance effect element driving circuit according to claim 1, wherein said exciting coil is positioned in parallel with said plurality of magneto-impedance effect elements.

3. A magneto-impedance effect element driving circuit according to claim 1 or 2, wherein a core of said exciting coil comprises said plurality of magneto-impedance effect elements.

4. A magneto-impedance effect element driving circuit according to claims 1, 2 or 3, wherein said coil driving circuit comprises a double-pole switch each.

5. A magneto-impedance effect element driving circuit according to any preceding claim, wherein said magneto-impedance effect elements are an amorphous wire each.

6. A magneto-impedance effect element driving circuit comprising:
a magneto-impedance effect element;
an exciting coil for applying a biased magnetic field to said magneto-impedance effect element;
a coil driving circuit for alternating the direction of a current flowing through said exciting coil;
an element driving circuit for driving said magneto-impedance effect element in synchronism with said coil driving circuit; and
a detecting circuit for detecting an end-to-end pulse voltage of said magneto-impedance effect element every time the direction of the exciting coil current is alternated.

7. A magneto-impedance effect element driving circuit according to claim 6, wherein said coil driving circuit comprises a double-pole switch.

8. A magneto-impedance effect element driving circuit according to claim 6 or 7, wherein said magneto-impedance effect element is an amorphous wire.
